# EUROPEAN PATENT APPLICATION

(11) **EP 4 207 282 A1**
(43) Date of publication of application: **05.07.2023**
(21) Application number: 21218429.5
(22) Date of filing: 31.12.2021
(51) Int. Cl.: H01L 27/02, H02H 9/04

(54) **A SEMICONDUCTOR DEVICE AND A METHOD OF MANUFACTURING A SEMICONDUCTOR DEVICE**

(71) Applicant: Nexperia B.V., 6534 AB Nijmegen (NL)
(72) Inventor: Utzig, Joachim, 22529 Hamburg (DE); Holland, Steffen, 22529 Hamburg (DE); Schnitt, Wolfgang, 22529 Hamburg (DE); Ritter, Hans-Martin, 22529 Hamburg (DE)
(74) Representative: Pjanovic, Ilija

(57) **Abstract**

This disclosure relates to a semiconductor device comprising a device with high clamping voltage (HVC device), and an OTS device. Such a semiconductor device provides very advantageous ESD protection. The semiconductor device can be realized in two ways: an OTS device and a device with high clamping voltage can be realized as discrete, independent devices that are combined in one semiconductor package, or an OTS device can be integrated into interconnect layers of a device with high clamping voltage by integration.

## Description

### FIELD

The present invention relates to a semiconductor device. The invention also relates to a method of manufacturing a semiconductor device.

### BACKGROUND

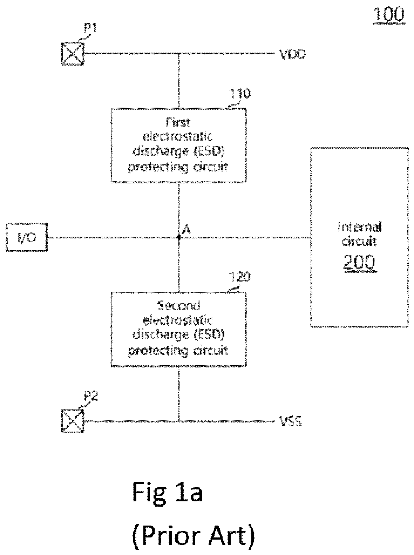

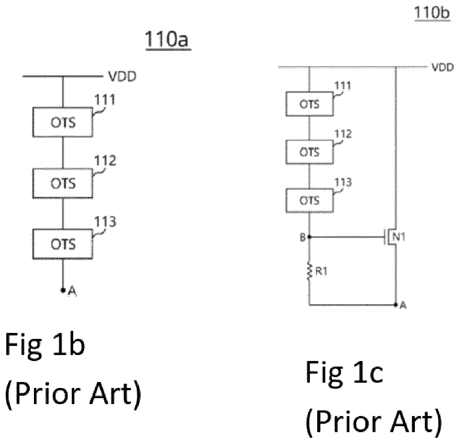

A semiconductor device known in the art is shown in Figures 1a, 1b and 1c.

In Figure 1a a semiconductor integrated circuit device is illustrated, wherein the semiconductor integrated circuit device has an electrostatic discharge (ESD) protection circuit.

The semiconductor integrated circuit device 100 includes a data pad I/O, a first ESD protecting circuit 110, a second ESD protecting circuit 120, and an internal circuit 200.

The data pad I/O is an interface that is used to input data from an external device to the internal circuit 200 and/or output data from the internal circuit 200 to the external device.

The first ESD protecting circuit 110 and the second ESD protecting circuit 120 are arranged between the data pad I/O and the internal circuit 200 so to protect the internal circuit 200 from an ESD surge that may flow through the data pad I/O coupled to terminals of a power voltage and a ground voltage.

The first ESD protecting circuit 110 is connected between the data pad I/O and a power voltage line VDD connected to a power voltage pad P1. The second ESD protecting circuit 120 is connected between the first ESD protecting circuit 110 and a ground voltage line VSS connected to a ground voltage pad P2. As shown in Figure 1a, a node A may be a connection node that connects the data pad I/O, the first ESD protecting circuit 110, and the second ESD protecting circuit 120 to each other.

The first ESD protecting circuit 110 includes at a resistance changeable device. The resistance changeable device is an ovonic threshold switch (OTS) device. As shown in Figure 1b, a first ESD protecting circuit 110a includes a plurality of OTS devices 111, 112, and 113 connected between the power voltage line VDD and the node A in series.

As shown in Figure 1c, the first ESD protecting circuit 110b includes the OTS devices 111, 112, and 113, a resistor R1, and an NMOS transistor N1. The OTS devices 111, 112 and 113 are connected between the power voltage line VDD and the resistor R1. The resistor R1 is connected between an output node B of the OTS devices 111, 112, and 113 and the node A. The node A is connected to the data pad I/O. The NMOS transistor N1 connects the power voltage line VDD to the node A in response to a voltage from the output node B of the OTS devices 111, 112, and 113.

It is also known in the prior art to use semiconductor structures only, thus no use of ovonic switching.

An example of this kind of prior art is a well-known combination of forward diodes in series with a high clamping device.

It is also known in the prior art to use a bipolar junction transistor (BJT) in a two pin configuration, where the emitter base diode provides the small capacitance, and the base collector junction gives the high clamping voltage. The disadvantage of the semiconductor devices as described above is that it has a non-symmetrical behaviour. To make the system symmetrical, more structures have to be added.

### SUMMARY

Various example embodiments are directed to the disadvantage as described above and/or others which may become apparent from the following disclosure.

According to an embodiment of the present invention a semiconductor device comprises a device with high clamping voltage (HVC device), and an OTS device.

The HVC device and the OTS device can be connected in series.

The HVC device and the OTS device can be combined in a package. The OTS device can be integrated in a metal stack of the HVC device.

According to an embodiment of the present invention a semiconductor device further comprises a first external pin and a second external pin.

According to an embodiment of the present invention a semiconductor device comprises a HVC device and OTS device. The HVC device comprises a p-n-junction with a high breakdown voltage, a first metallization layer and a second metallization layer. The OTS device is positioned between the first metallization layer and the second metallization layer of the HVC device. In this way the OTS device is integrated within the HVC device. The semiconductor device further comprises a first external pin and a second external pin.

According to an embodiment of the present invention a semiconductor device comprises a HVC device and OTS device. The HVC device comprises two p-n-junctions, wherein a first p-n junction is realized by a first p layer and a n layer, and wherein a second p-n junction is realized by a second p layer and the n layer. The HVC device further comprises a first metallization layer, a second metallization layer, a third metallization layer and a fourth metallization layer. The OTS device comprises a first OTS layer and a second OTS layer. The first metallization layer is positioned on the top of the first p layer, the first OTS layer is positioned on the top of the first metallization layer, and the second metallization layer is positioned on the top of the first OTS layer, so that the first OTS layer is sandwiched between the first metallization layer and the second metallization layer. The third metallization layer is positioned on the top of the second p layer, the second OTS layer is positioned on the top of the third metallization layer, and the fourth metallization layer is positioned on the top of the second OTS layer, so that the second OTS layer is sandwiched between the third metallization layer and the fourth metallization layer. The semiconductor device further comprises a first external pin and a second external pin.

According to an embodiment of the present invention a semiconductor device comprises a HVC device and an OTS device. The HVC device comprises a p-n-junction with a high breakdown voltage. The HVC device further comprises a first metallization layer and a second metallization layer. The OTS device is positioned between the first metallization layer and the second metallization layer of the HVC device. The OTS device comprises multiple OTS layers that are positioned between the first metallization layer and the second metallization layer of the HVC device. The HVC device further comprises a first external pin and a second external pin.

According to an embodiment of the present invention a HVC device comprises two p-n-junctions, a first p-n junction and a second p-n junction. The first p-n junction is realized by a first layer of a first polarity and a second layer of a second polarity. The second p-n junction is realized by the second layer and a third layer of the first polarity.

The OTS device as described in the previous embodiments is preferably tuned so that the robustness of the OTS device mirrors the robustness of the HVC device. This mirroring of the robustness secures achieving a lowest capacitance per robustness ratio for the semiconductor device comprising said HVC device and OTS device.

The high voltage clamp within the HVC device can be also realized by a BJT device, a MOS device or any other applicable semiconductor structure with a sufficiently high clamping voltage.

The high voltage clamp of the HVC device has preferably a symmetrical electrical characteristic. In this way the series connection of an OTS device and a HVC device is symmetrical too.

The semiconductor device as described in the above embodiments provides an advantageous ESD protection wherein the semiconductor device has both, a low capacitance and a high breakdown voltage.

The present invention also related to a method of producing a semiconductor device as described in the above embodiments.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figures 1a, 1b and 1c show a known semiconductor device;
Figures 2a and 2b illustrate semiconductor devices according to embodiments of the present invention;
Figures 3a, 3b and 2c illustrate semiconductor devices according to embodiments of the present invention.

### DETAILED DESCRIPTION

According to an embodiment of the present invention, a semiconductor device with an ESD protection is provided, which semiconductor device comprises an OTS device and a device with high clamping voltage.

Such a semiconductor device solves the problems that are present in the known semiconductor devices. The known semiconductor devices with a high clamping voltage have to be relatively big, since there is a large amount of power to be dissipated. Accordingly these devices that are relatively big, have a high capacitance. This makes them unsuitable for high speed data lines.

Known ESD protection devices with a relatively small capacitance have a small holding voltage, making them unsuitable for the high voltage applications.

This is also true for the known OTS devices that are known to be used as a part of onchip ESD protection structures. These OTS devices can offer a relatively low capacitance, low trigger and low holding voltages.

The semiconductor device according to an embodiment of the present invention, the semiconductor device comprising an OTS device and a device with high clamping voltage, does not have the above mentioned problems known in the prior art.

The OTS device has a low capacitance which compensates for the high capacitance of the device with high clamping voltage.

The device with high clamping voltage has a high clamping voltage, which adds to a relatively small clamping voltage of the OTS device.

Therefore, the semiconductor device according to the embodiment of the present invention, which is a combination the OTS device and the device with high clamping voltage, is a semiconductor device with both a relatively small capacitance and a relatively high clamping voltage.

According to an embodiment of the invention a semiconductor device which is a combination of an OTS device and a device with high clamping voltage may be realized in at least two ways:
- an OTS device and a device with high clamping voltage can be realized as discrete, independent devices that are combined in one semiconductor package, or
- an OTS device can be integrated into interconnect layers of a device with high clamping voltage by integration.

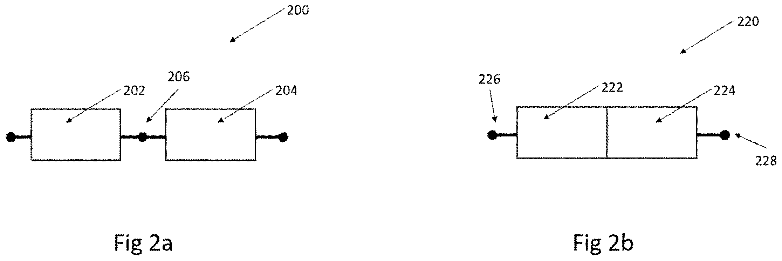

A semiconductor device according to an embodiment of the present invention is shown in Figure 2a. The semiconductor device 200 comprises an OTS device 202 and a device with high clamping voltage 204 connected in series. The device with high clamping voltage 204 is also called a high voltage clamp (HVC) device.

The connection 206 between the OTC device and the HVC device can be realized by a bond-wire, a leadframe, or similar.

A semiconductor device according to an embodiment of the present invention is shown in Figure 2b. The semiconductor device 220 comprises an OTS device 222 and a HVC device 224 combined within one package. Such a package can have two external pins, a first external pin 226 and a second external pin 228. In this exemplary embodiment shown in Figure 2b, the first external pin 226 is connected to the left side of the OTS device 222 and the second external pin 228 is connected to the right side of the HVC device 224. In this case the OTS device can be integrated in a metal stack of the HVC device.

In an embodiment of the present invention a semiconductor device comprises an OTS device and a HVC device, wherein the OTS device is positioned between two interconnect layers of the HVC device.

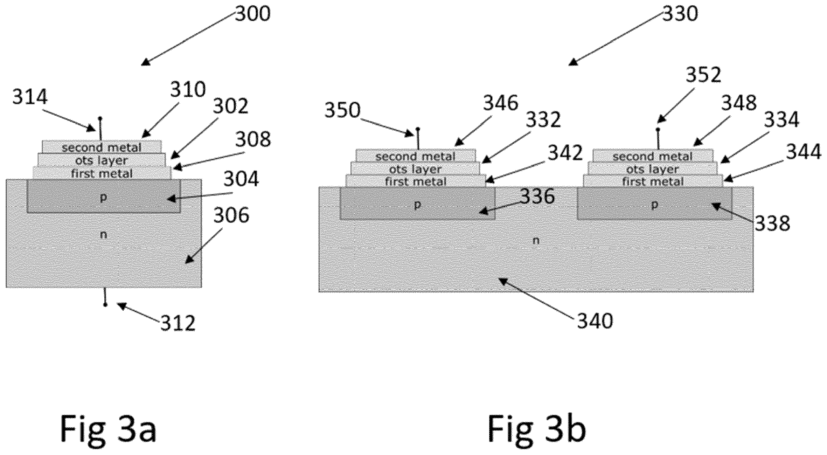

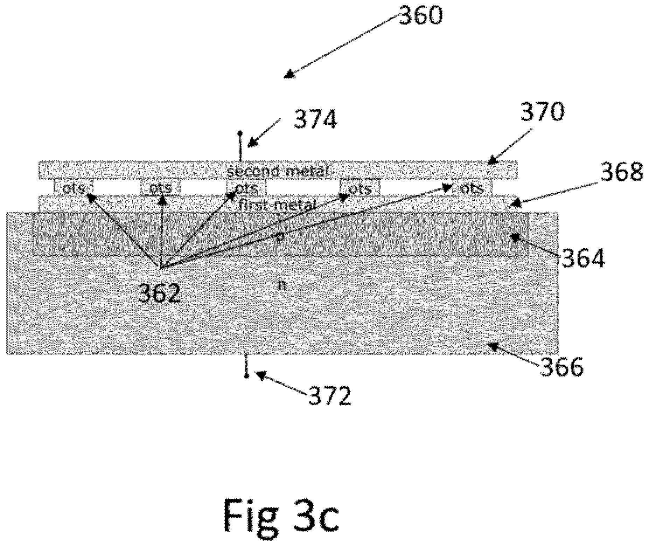

Three exemplary embodiments of the present invention are shown in Figures 3a, 3b and 3c.

In an exemplary embodiment of the present invention shown in Figure 3a, a semiconductor device 300 comprises:
- a HVC device, which HVC device comprises a p-n-junction 304, 306 with a high breakdown voltage, a first metallization layer 308 and a second metallization layer 310, and
- an OTS device 302 which is positioned between the first metallization layer 308 and the second metallization layer 310 of the HVC device.

The HVC device further comprises a first external pin 312 and a second external pin 314.

The present invention includes all variation of the above described embodiment. For example, the semiconductor device can comprise more than two metallization layers, and the OTS device can be position between two of any of these multiple metallization layers, e.g. between the third and the fourth metallization layers in case that there are four metallization layers. Moreover, the present invention also includes all polarization combinations, e.g. the junction can be also a n-p-junction, etc. The junction can be positioned deep in the silicon, it comprise a stack of junctions, etc.

In an exemplary embodiment of the present invention shown in Figure 3b, a semiconductor device 330 comprises:
- a HVC device, which HVC device comprises a first metallization layer 342, a second metallization layer 346, a third metallization layer 344 and a fourth metallization layer 348, and
- an OTS device 332, 334, which OTS device comprises a first OTS layer 332 and a second OTS layer 334,
- wherein the first metallization layer 342 is positioned on the top of the first p layer 336, the first OTS layer 332 is positioned on the top of the first metallization layer 342, and the second metallization layer 346 is positioned on the top of the first OTS layer 332, so that the first OTS layer 332 is sandwiched between the first metallization layer 342 and the second metallization layer 346, and
- wherein the third metallization layer 344 is positioned on the top of the second p layer 338, the second OTS layer 334 is positioned on the top of the third metallization layer 344, and the fourth metallization layer 348 is positioned on the top of the second OTS layer 334, so that the second OTS layer 334 is sandwiched between the third metallization layer 344 and the fourth metallization layer 348.

According to an embodiment of the present invention a HVC device can further comprise two p-n-junctions, a first p-n junction and a second p-n junction. The first p-n junction is realized by a first layer of a first polarity and a second layer of a second polarity. The second p-n junction is realized by the second layer and a third layer of the first polarity.

In exemplary embodiment shown in Figure 3b, a HVC device comprises two p-n-junctions 336, 338, 340, wherein a first p-n junction is realized by a first p layer 336 and a n layer 340, and wherein a second p-n junction is realized by a second p layer 338 and the n layer 340.

The semiconductor device can further comprise a first external pin 350 and a second external pin 352.

This exemplary embodiment shown in Figure 3b is an anti-serial connection of two semiconductor devices shown in Figure 2b.

In an exemplary embodiment of the present invention shown in Figure 3c, a semiconductor device 360 comprises:
- a HVC device, which HVC device comprises a p-n-junction 364, 366 with a high breakdown voltage, a first metallization layer 368 and a second metallization layer 370, and
- an OTS device 362 which is positioned between the first metallization layer 368 and the second metallization layer 370 of the HVC device, wherein the OTS device 362 comprises multiple OTS layers 362 that are positioned between the first metallization layer 368 and the second metallization layer 370 of the HVC device.

The HVC device further comprises a first external pin 372 and a second external pin 374.

As shown in the previous embodiments of the present invention, the sandwiching of the OTS device between two metal layers of the HVC device may be a full area or locally only.

The OTS area of the OTS device would preferably be tuned so that the robustness of the OTS device mirrors the robustness of the HVC device, which secures achieving a lowest capacitance per robustness ratio for the semiconductor device comprising said HVC device and OTS device.

The high voltage clamp within the HVC device might be realized as a p-n-junction, as shown in the exemplary embodiments shown in Figures 3a, 3b and 3c, but it could be also realized by a BJT device, a MOS device or any other semiconductor structure with a sufficiently high clamping voltage and sufficiently high robustness.

Preferably the high voltage clamp has a symmetrical electrical characteristic, because then the series connection of an OTS device and a HVC device is symmetrical too.

A big advantage of integrating the OTS device into the interconnect layers of the HVC device is that existing clamp concepts and diffusion processes can be re-used with changes only in the back end that does not change the principal clamp behaviour.

The semiconductor devices as described in the previous embodiments provide very advantageous ESD protection.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A semiconductor device comprising:
- a device with high clamping voltage (HVC device), and
- an OTS device.

2. A semiconductor device as claimed in claim 1, wherein the HVC device and the OTS device are connected in series.

3. A semiconductor device as claimed in any of the previous claims, wherein the HVC device and the OTS device are combined in a package.

4. A semiconductor device as claimed in any of the previous claims, wherein the OTS device is integrated in a metal stack of the HVC device.

5. A semiconductor device as claimed in any of the previous claims, wherein the semiconductor device further comprises a first external pin and a second external pin.

6. A semiconductor device as claimed in any of the previous claims,
- wherein the HVC device comprises:
∘ at least one p-n-junction with a high breakdown voltage,
∘ a first metallization layer, and
∘ a second metallization layer,
- wherein the OTS device is positioned between the first metallization layer and the second metallization layer the HVC device.

7. A semiconductor device as claimed in any of the previous claims,
- wherein the HVC device comprises:
∘ a first metallization layer, a second metallization layer, a third metallization layer and a fourth metallization layer,
- wherein the OTS device comprises a first OTS layer and a second OTS layer,
- wherein the first metallization layer is positioned on the top of the first p layer, the first OTS layer is positioned on the top of the first metallization layer, and the second metallization layer is positioned on the top of the first OTS layer, so that the first OTS layer is sandwiched between the first metallization layer and the second metallization layer,
- wherein the third metallization layer is positioned on the top of the second p layer, the second OTS layer is positioned on the top of the third metallization layer, and the fourth metallization layer is positioned on the top of the second OTS layer, so that the second OTS layer is sandwiched between the third metallization layer and the fourth metallization layer.

8. A semiconductor device as claimed in any of the previous claims,
- wherein the HVC device comprises:
∘ two p-n-junctions, a first p-n junction and a second p-n junction, wherein the first p-n junction is realized by a first layer of a first polarity and a second layer of a second polarity, and wherein the second p-n junction is realized by the second layer and a third layer of the first polarity.

9. A semiconductor device as claimed in any of the previous claims, wherein the OTS device is tuned so that the robustness of the OTS device mirrors the robustness of the HVC device.

10. A semiconductor device as claimed in any of the previous claims, wherein the high voltage clamp within the HVC device is realized by a BJT device, a MOS device or any other applicable semiconductor structure with a sufficiently high clamping voltage.

11. A semiconductor device as claimed in any of the previous claims, wherein the high voltage clamp of the HVC device has a symmetrical electrical characteristic.

12. A method of producing a semiconductor device as claimed in any of the previous claims.
